(19) Europäisches Patentamt
European Patent Office
Office européen des brevets

(11) **EP 3 162 914 A1**

(12) **EUROPEAN PATENT APPLICATION**

(43) Date of publication:
**03.05.2017 Bulletin 2017/18**

(51) Int Cl.:
*C23C 16/448* *(2006.01)*   *C23C 16/455* *(2006.01)*

(21) Application number: **16193826.1**

(22) Date of filing: **13.10.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **02.11.2015 EP 15192571 P**

(71) Applicant: **IMEC VZW**
**3001 Leuven (BE)**

(72) Inventor: **CAYMAX, Matty**
**3001 Leuven (BE)**

(74) Representative: **Patent Department IMEC**
**IMEC vzw**
**Patent Department**
**Kapeldreef 75**
**3001 Leuven (BE)**

(54) **APPARATUS AND METHOD FOR DELIVERING A GASEOUS PRECURSOR TO A REACTION CHAMBER**

(57) The invention is related to an apparatus and method for delivering a gaseous precursor to a reaction chamber, wherein a mixture of a carrier gas and a precursor vapour is transported from a recipient where the precursor is vaporized, to the reaction chamber. A gas mixture transport line coupled to the recipient is maintained at the same temperature as the recipient and comprises a pressure control device configured to maintain the pressure upstream of the device at a pre-defined level, before releasing the mixture to an area at a lower pressure than the predefined level, whilst remaining at the abovenamed temperature. The controlled pressure drop leads to a reduction of the precursor vapour's partial pressure in the mixture, allowing the supply to the reaction chamber to be delivered at a lower temperature without condensation of the precursor. A diluent gas flow may be added to the carrier/precursor mixture prior to the passage through the pressure control device, which allows an additional reduction of the partial pressure to be realized.

FIG. 2

## Description

### Field of the Invention

The invention is related to the production and transport of gaseous precursors, to be used as reagents in a reaction chamber. The main field of application is the delivery of precursor gas to a substrate placed in a reaction chamber, in order to deposit a layer on the substrate. Some examples of processes to which the invention is applicable are known as Chemical Vapour Deposition (CVD) Atomic Layer Deposition (ALD) and Atomic Layer Epitaxy (ALE).

### State of the art.

All CVD, ALD and similar deposition processes need chemical precursors, which can be permanent gases, liquids or solids. In the two latter cases, the precursor needs to be volatilized (the gas phase of the precursor is commonly called 'vapour') in order to be able to inject it into the reaction chamber of a reactor. This is not difficult for precursors with a rather high vapour pressure at room temperature, for example trimethylaluminium (TMA) which has a vapour pressure of about 1333 Pa at room temperature. In this case, the vapour may be drawn off from a certain amount of TMA in a closed vessel and transported with an inert carrier gas, e.g. argon ('vapour draw system'). Alternatively, a 'bubbler arrangement' may be used in which an inert carrier gas is bubbled through a liquid or molten precursor so that the carrier gas becomes loaded with the precursor, which can as such be transported into the reactor. The partial pressure of the precursor gas in this mixture is equal to the vapour pressure of the precursor at room temperature. The relatively high vapour pressure ensures that a sufficient amount of the precursor gas is supplied to the reactor for deposition. The 'vapour draw' approach is mandatory in case of solid precursors.

In case the precursor has a very low vapour pressure at room temperature, the vapour pressure may be raised by heating. This again can be done in vapour draw or bubbler mode. For some precursors however, very high temperatures are required, for example in the case of $HfCl_4$ (Hafnium Tetrachloride), which has a vapour pressure of about 133.3 Pa at 170°C. Working with lower vapour pressures would reduce the amount of precursor that can be injected into the reactor which is practically not workable. The major drawback in these cases is that the gas mixture must be maintained at a high temperature at any moment until its injection into the reactor. Any cold spot on the way between the vaporizer system and the reactor will result in condensation, so that no gaseous precursor reaches the reactor. Furthermore, condensation may lead to clogging of controlling components (valves, mass flow controllers etc) or at restrictions in the piping system. This can be a major limitation in case the temperature is above the critical operating temperature of conventional construction and sealing materials such as O-rings, especially in complex constructions such as showerheads or injection systems including sensitive metering valves. Most constructions cannot tolerate temperatures above roughly 125°C.

A known solution to this problem consists in the dilution of the carrier/precursor mixture, leading to a reduction of the precursor's partial pressure, so that the mixture may be transported at lower temperatures without the risk of condensation. This technique however requires the supply of a dilution gas through suitable supply lines equipped with regulating means, with the requirement that these supply lines are kept at the higher temperature over at least a given distance. It is therefore a technically complex and expensive solution.

Another known solution involves the reduction of the pressure of the gas mixture by releasing a portion of the mixture into the atmosphere, for example by venting. This is however not an economical solution as an important amount of the precursor is wasted.

### Summary of the invention

The invention is related to an apparatus, an installation and to a method as disclosed in the appended claims, wherein the above-described drawbacks are overcome. The invention is related to an apparatus and method for delivering a gaseous precursor to a reaction chamber, wherein a mixture of a carrier gas and a precursor vapour is transported from a recipient where the precursor is vaporized, to the reaction chamber. A gas mixture transport line coupled to the recipient is maintained at the same temperature as the recipient and comprises a pressure control device configured to maintain the pressure upstream of the device at a pre-defined level, before releasing the mixture to an area at a lower pressure than the predefined level, whilst remaining at the abovenamed temperature. The controlled pressure drop leads to a reduction of the precursor vapour's partial pressure in the mixture, allowing the supply to the reaction chamber to be delivered at a lower temperature without condensation of the precursor. A diluent gas flow may be added to the carrier/precursor mixture prior to the passage through the pressure control device, which allows an additional reduction of the partial pressure to be realized.

The invention is firstly related to an apparatus for delivering a gaseous precursor to a reaction chamber, the apparatus comprising :

- a recipient for holding a quantity of the precursor in a solid or liquid state at a given temperature and pressure so as to vaporize the precursor,
- a carrier gas supply line, for supplying a carrier gas to the recipient,
- an gas mixture transport line for transporting a mixture of the carrier gas and a vapour of the precursor out of the recipient, the gas mixture transport line extending between the recipient and an outlet section of the gas mixture transport line, the outlet section being configured to be coupled to a supply line, external to the apparatus, for supplying the mixture to said reaction chamber,

wherein the recipient and the gas mixture transport line are configured to be maintained at a single predefined temperature, and wherein the gas mixture transport line comprises a pressure control device configured to maintain the pressure upstream of the device at a predefined level. The pressure control device is configured to maintain said upstream pressure without releasing a portion of the mixture into the atmosphere.

According to a preferred embodiment, the pressure control device is the only means for reducing the partial pressure of the gas mixture, included in the apparatus, i.e. the apparatus comprises no other means for reducing the pressure of the gas mixture. In this embodiment therefore, the apparatus comprises no means for diluting the gas mixture by mixing it with a diluent gas.

According to another embodiment, the apparatus further comprises a diluent gas supply line, for supplying a diluent gas to said gas mixture transport line, wherein the diluent gas supply line joins the gas mixture transport line at a location upstream of the pressure control device.

According to specific embodiments, the apparatus comprises a furnace comprising the recipient, the gas mixture transport line and at least a portion of the carrier gas supply line and - if applicable - at least a portion of the diluent gas supply line. According to an embodiment, the pressure control device is a back pressure regulating valve.

The invention is equally related to an installation for depositing a layer on a substrate by chemically reacting a gaseous precursor with chemical elements of the substrate, said installation comprising :

- an apparatus according to the invention,
- a carrier gas/precursor vapour mixture supply line coupled to the outlet section of the gas mixture transport line,
- a deposition reactor comprising a reaction chamber coupled to the carrier gas/precursor vapour mixture supply line.

The invention is equally related to a method for delivering a gaseous precursor to a reaction chamber, the method comprising the steps of

- heating a precursor in a recipient to a heating temperature, wherein the heating temperature is determined on the basis of a pre-determined vapour pressure of the precursor and vaporizing the precursor at said heating temperature,
- supplying a predefined flow of a carrier gas to the recipient,
- transporting a mixture of carrier gas and precursor vapour away from the recipient through a gas mixture transport line, while maintaining said gas mixture transport line at said heating temperature, wherein the gas mixture transport line is provided with a pressure control device, configured to maintain the pressure upstream of said device at a predefined level,

- maintaining the total pressure in the gas mixture transport line upstream of said pressure control device at a predefined level,
- reducing the total pressure of said mixture to a value lower than said predefined level, downstream of the pressure control device, thereby reducing the partial pressure of the precursor vapour in the mixture,
- transporting the mixture towards the reaction chamber, while maintaining the mixture at a temperature lower than the heating temperature, and above the condensation temperature of the precursor vapour in the mixture.

According to an embodiment, a diluent gas flow is supplied at a location in the gas mixture transport line upstream of the pressure control device, so that a diluted mixture flows through said device.

According to specific embodiments, the precursor is $HfCl_4$ or $MoCl_5$ and the carrier gas is chosen from the group consisting of Ar, He and $H_2$.

**Brief description of the figures**

Figure 1 illustrates a schematic image of an apparatus according to a first embodiment of the invention.
Figure 2 illustrates a schematic image of an apparatus according to a second embodiment of the invention.

**Detailed description of the invention**

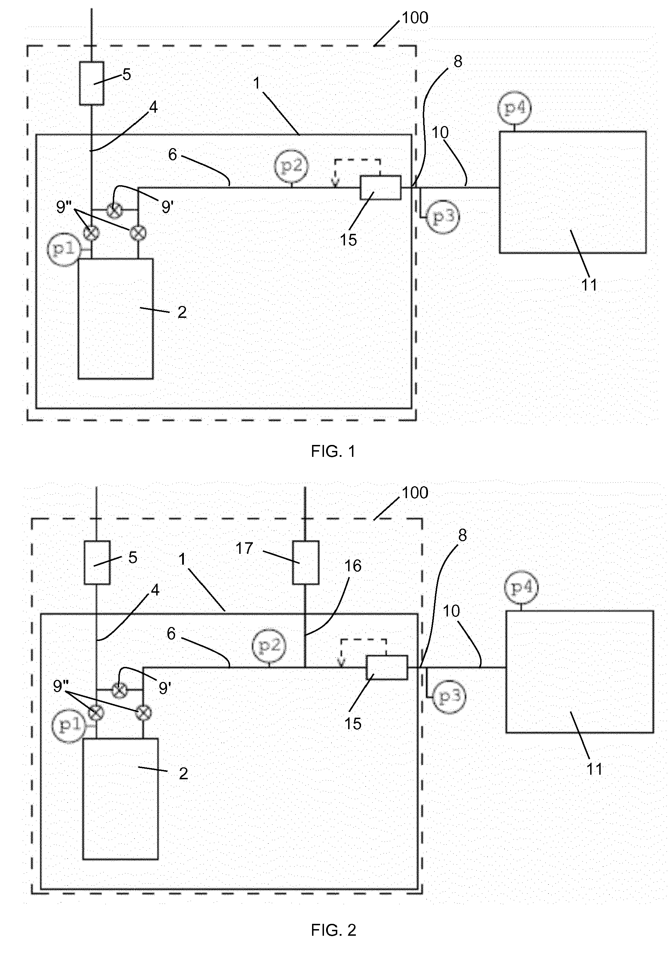

The apparatus and the method of the invention will be described hereafter with reference to the enclosed drawings. The drawings are schematic only and are not drawn to scale. Figure 1 shows a first embodiment of an apparatus 100 according to the invention, coupled to the reaction chamber 11 of a deposition reactor. The apparatus 100 comprises a furnace 1. Inside the furnace is a canister 2 in which a precursor in the solid state is loaded, the precursor being for example in the form of a powder loaded into the canister. The canister may be any type of canister applied in presently known sublimation systems. The temperature in the furnace 1 and thereby in the canister 2 is raised to a value T1 at which the vapour pressure of the precursor is at a predefined level sufficient to result in sufficient vapour production, e.g. a vapour pressure of about 133,3 Pa. The precursor is vaporized at this temperature in the canister, by reducing the pressure to the vapour pressure, so that the vapour is in equilibrium with the solid precursor at the predefined vapour pressure.

A given mass flow of an inert carrier gas is then supplied to the canister 2 through carrier gas supply line 4, which is provided with a mass flow controller 5. The mass flow controller may be a part of the apparatus 100, as shown in the drawings, or it may be external to the apparatus. The carrier gas flows through the canister and draws away the precursor vapour so that a mixture of carrier gas and precursor vapour flows out of the canister into a gas mixture transport line 6 coupled to the canister 2. The gas mixture transport line 6 is included in the furnace 1, i.e. the canister 2 and the transport line 6 are configured to be maintained at a single predefined temperature T1. The gas mixture transport line 6 extends between the canister 2 and an outlet section 8 of the transport line 6, which corresponds to the outlet section of the furnace 1. In other words, upstream of the outlet section 8, the temperature is maintained at T1 whereas downstream of the outlet section 8, the temperature is not maintained at T1 (for example it may be room temperature or any temperature lower than T1). The valves 9'/9" are configured to allow installation and exchanging of the canister 2. When the apparatus 100 is operational, the middle valve 9' is closed and the left and right valves 9" are open.

At the inlet of the canister 2, the total pressure is p1. In the canister 2, a gas mixture of carrier gas and precursor vapour is formed, wherein the partial pressure of the precursor vapour in the mixture substantially remains at the above-described vapour pressure of the particular precursor type that is being used. Downstream of the canister 2, the total pressure drops to a value p2 lower than p1 due to the flow resistance inside the canister 2. The value p1-p2 depends on the carrier gas mass flow injected into the canister (as controlled by the mass flow regulator 5), and the geometry and size of the canister 2.

According to the embodiment of the invention illustrated in Figure 1, the total pressure is reduced in a controlled manner from a predefined set value p2 to a lower value p3, whilst maintaining the gas mixture at the temperature T1 of the furnace 1. For this purpose, a pressure control device 15 is provided in the gas mixture transport line 6, upstream of the exit section 8 of the transport line 6. It is a device which allows passage of a fluid whilst maintaining the pressure of the fluid upstream of the device at a predefined value, and without releasing a portion of the fluid (i.e. without venting). According to the preferred embodiment illustrated in Figure 1, this device is a back pressure regulating valve (BPR), known as such in the art. A BPR valve is normally closed and opens when the inlet pressure exceeds a predefined value, for example by working against a spring force. In this way, the inlet pressure is maintained at the predefined value. This is contrary to a normal pressure regulating valve which is normally open and closes only when the outlet pressure exceeds a given value.

In the apparatus of the invention, the back pressure regulating (BPR) valve 15 thus controls the pressure p2 to a pre-defined value (symbolized by the arrow). The geometry and material of the gas mixture transport line 6 is preferably chosen such that a pressure drop due to this transport line itself is negligible, i.e., the pressure p2 is substantially the same anywhere in line 6, up to the back pressure regulating valve 15. By controlling the pressure p2 to a pre-defined set value, this pressure p2 also determines, together with the carrier gas flow, the pressure p1 at the inlet of the canister.

Downstream of the furnace 1, a carrier/precursor mixture supply line 10 is coupled to the outlet section 8 of the gas mixture transport line 6. Through the supply line 10, the gas mixture flows to the reaction chamber 11 of a deposition reactor, which may be a CVD or ALD reactor as known in the art. The supply line 10 is therefore not a part of the furnace 1 and may be for example at room temperature. The pressure p4 in the reactor is pre-defined based on the required conditions of the deposition process.

The total pressure p3 at and directly beyond the outlet section 8 of the gas mixture transport line 6 is defined by the pre-defined pressure p4 in the reaction chamber and the pressure loss $\Delta p$ in the supply line 10, which itself depends on the carrier gas mass flow and the geometry (diameter and length for a cylindrical pipe plus any restrictions presented by bends or gas flow controlling devices such as valves or the like) of the supply line 10. The flow characteristics (e.g. geometry, materials, etc) of the BPR valve 15, the outlet section 8 and supply line 10 are such that the value p3 is substantially not influenced by the value of p2. In other words, the gas mixture is released by the pressure control device 15 into an area (the inlet of the supply line 10), which is at a lower pressure than the predefined set value p2. The pressure drop from the set value p2 to p3 results in a drop in the precursor's partial pressure by a factor p3/p2, while the precursor/carrier mixture is maintained at the high temperature T1. Within the physical limits of the various components of the installation, a higher set value of the pressure p2 thereby results in a more important decrease of the precursor's partial pressure.

The lower partial pressure of the precursor vapour corresponds to the vapour pressure for the precursor at a condensation temperature T2 that is lower than the temperature T1 of the furnace. When the mixture then leaves the furnace 1, condensation of the precursor gas is avoided as long as the temperature of the supply line 10 is higher than or equal to T2. If the reduced condensation temperature T2 is 20°C or lower, this means that the supply line 10 can be maintained at room temperature without danger of condensation of the precursor gas. The decrease in partial pressure takes place before the gas mixture leaves the furnace 1, i.e. while the mixture is maintained at a given high temperature T1.

It is a characteristic of the invention that the pressure control device 15 is included in the mixture transport line 6, i.e. in a portion of the inventive apparatus that is configured to be maintained at the same temperature as the recipient 2 in which the precursor is vaporized. This characteristic enables a partial pressure reduction prior to the lowering of the temperature of the mixture, by no other means than the pressure control device. The use of the pressure control device in this way makes it possible to supply the precursor gas at lower temperatures, without necessitating a dilution of the carrier/precursor mixture. Nevertheless, dilution of the mixture can be additionally applied in combination with the pressure control device, as explained in the next paragraph.

According to a further embodiment illustrated in Figure 2, a diluent gas is added to the gas mixture transport line 6 via a second supply line 16 provided with a second mass flow controller 17 (which may or may not be a part of the apparatus 100). The diluted gas mixture then flows through the back pressure control valve 15. The addition of the diluent gas causes a reduction of the partial pressure of the precursor gas in the mixture by a factor equal to the ratio of the carrier gas flow (as controlled by the first mass flow controller 5) to the sum of the carrier gas flow and the diluent gas flow (the latter controlled by the second mass flow controller 17).

The subsequent pressure drop from p2 to p3 as described with reference to Figure 1 causes an additional decrease of the partial pressure of the precursor gas by a factor p3/p2. This double decrease of the partial pressure makes it possible to bring down this partial pressure to lower levels compared to the embodiment of Figure 1.

Instead of a sublimation canister 2, a bubbler may be applied when the precursor is in liquid form. The diluent gas may be the same as the carrier gas, or it may be different. Like the carrier gas, the diluent gas is however inert with respect to the precursor gas. The invention is not limited to an apparatus wherein the canister and the gas mixture transport line 6 are mounted in a furnace 1. Other means for maintaining the canister and the gas mixture transport line 6 at the same temperature may be applied.

The invention is equally related to the installation as shown in Figures 1 and 2 as a whole, i.e. including the apparatus 100, the supply line 10 and a deposition reactor comprising the reaction chamber 11. The invention is equally related to a method for delivering a gaseous precursor to a reaction chamber. The method has been described above with reference to the drawings. A more general description of the method is as follows :

- heating a precursor in a recipient 2 so as to vaporize the precursor, wherein the heating temperature is determined on the basis of a pre-determined vapour pressure of the precursor, the vapour pressure being sufficient to produce a significant supply of precursor to the reaction chamber. As stated before in this description, 'heating the precursor so as to vaporize the precursor' is to be understood as 'heating the precursor to a heating temperature that is determined on a pre-determined vapour pressure and vaporizing the precursor at said heating temperature.
- supplying a predefined flow of a carrier gas to the recipient 2, as may be controlled by a mass flow controller 5,
- transporting a mixture of carrier gas and precursor vapour away from the recipient 2 through a gas mixture transport line 6, while maintaining said gas mixture transport line at said heating temperature, wherein the gas mixture transport line is provided with a pressure control device 15, configured to maintain the pressure upstream of said device at a predefined level. The pressure control device is preferably a backpressure regulating valve as known in the art,
- maintaining the total pressure in the gas mixture transport line upstream of said pressure control device 15 at a predefined level p2, by applying an appropriate setting to the pressure control device 15,
- reducing the total pressure of said mixture to a value p3 lower than said predefined level, downstream of the pressure control device 15, thereby reducing the partial pressure of the precursor vapour in the mixture. The pressure p3 may be determined by a pre-defined pressure p4 in the reaction chamber 11 and by the pressure loss in a supply line 10 towards said reaction chamber,
- transporting the mixture towards the reaction chamber 11, while maintaining the mixture at a temperature lower than the heating temperature, and above the condensation temperature of the precursor vapour in the mixture.

According to a preferred embodiment of the method, a diluent gas is added to the gas mixture transport line 6 upstream of the pressure control device 15, so that a diluted mixture flows through said device.

## Examples

The effectiveness of the apparatus and method of the invention is illustrated by the following examples. Table 1 gives values for a number of the parameters described above. Some parameters are common to all the examples : the length and diameter of the supply line 10 are 2 m and 1.27 cm respectively. The pressure loss over the supply line 10 is calculated using standard formulae known in the art. The diluent gas is the same as the carrier gas. The pressure drop over the canister is estimated to be 799,8 Pa. Values in bold type are predefined. The other values are derived from those predefined values in the manner described above or by known formulas. The examples are related to $HfCl_4$ and $MoCl_5$ as exemplary precursors. These precursors have a vapour pressure of about 133.3 Pa at elevated temperatures of 170°C and 120°C respectively, whereas at room temperature, the vapour pressures are too low to be of interest in a deposition process. The flow rates in table 1 are expressed in standard litres per minute (slm). The SI unit for this parameter is $Pa.m^3/s$ with 1 slm = 1.69 $Pa.m^3/s$.

Table 1

| Precursor type | HfCl4 | HfCl4 | MoCl5 | MoCl5 | MoCl5 |
|---|---|---|---|---|---|
| Temperature in furnace (°C) | **170** | **170** | **120** | **120** | **120** |
| Precursor Partial pressure in canister $p_c$ (Pa) | 125.3 | 125.3 | 134.4 | 134.4 | 134.4 |
| Carrier gas /diluent gas | **Ar** | **H2** | **Ar** | **He** | **H2** |
| Carrier gas flow (slm) F1 | **0.15** | **0.15** | **0.15** | **0.15** | **0.15** |
| Diluent gas flow (slm) F2 | **5** | **20** | **1** | **5** | **0** |
| p2 (Pa) | **2666** | **13330** | **2666** | **2666** | **13330** |
| p1 (Pa) = p2 + 799.8 | 3465.8 | 14129.8 | 3465.8 | 3465.8 | 14129.8 |
| $\triangle$p supply line (Pa) | 559.9 | 66.7 | 104 | 479.9 | 13.3 |
| p4 (Pa) | **266.6** | **266.6** | **266.6** | **266.6** | **266.6** |
| p3 (Pa) = p4 + $\triangle$p | 826.5 | 333.3 | 370.6 | 693.2 | 279.9 |
| Precursor Partial pressure at furnace exit (Pa) | 1.2 | 0.03 | 2.4 | 1.1 | 2.8 |
| Precursor Condensation temperature at furnace exit (°C) | 104.4 | 63.3 | 23.4 | 17.6 | 24.4 |

The precursor partial pressure at the furnace exit is calculated as :

$$p_c * \frac{F1}{F1+F2} * \frac{p_3}{p_2}$$

These calculations prove that the condensation temperature can be significantly reduced by a suitable choice of a number of parameters, most notably the carrier gas type, the diluent mass flow rate, and the pressure p2 which in turn determines the pressure p1 in the canister through the action of the BPR. In the case of $MoCl_5$, it is possible to reduce the condensation temperature to room temperature or lower, even without applying a diluent gas flow, as illustrated in the last example where the diluent gas flow is zero (i.e. corresponding to the embodiment of Figure 1). For precursors such as $HfCl_4$, which have very low vapour pressure at room temperature, the diluent gas flow is regarded as necessary in order to bring down the condensation temperature to levels which are still higher than room temperature but which nevertheless allow the supply line 10 towards the reactor to be maintained at lower temperatures than the temperature at which the vapour is produced, and which are low enough so as to be compatible with standard construction materials of the precursor injection systems in conventional reactors.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

**Claims**

1. An apparatus (100) for delivering a gaseous precursor to a reaction chamber (11), the apparatus comprising :

   • a recipient (2) for holding a quantity of the precursor in a solid or liquid state at a given temperature and pressure so as to vaporize the precursor,
   • a carrier gas supply line (4), for supplying a carrier gas to the recipient,
   • a gas mixture transport line (6) for transporting a mixture of the carrier gas and a vapour of the precursor out of the recipient, the gas mixture transport line extending between the recipient (2) and an outlet section (8) of the gas mixture transport line, the outlet section being configured to be coupled to a supply line (10), external to the apparatus (100), for supplying the mixture to said reaction chamber (11),

   wherein the recipient (2) and the gas mixture transport line (6) are configured to be maintained at a single predefined temperature, and wherein the gas mixture transport line (6) comprises a pressure control device (15) configured to maintain the pressure upstream of the device at a predefined level.

2. Apparatus according to claim 1, wherein the pressure control device (15) is the only means for reducing the pressure of the gas mixture, included in the apparatus.

3. Apparatus according to claim 1, further comprising a diluent gas supply line (16), for supplying a diluent gas to said gas mixture transport line (6), wherein the diluent gas supply line joins the gas mixture transport line at a location upstream of the pressure control device (15).

4. Apparatus according to claim 1 or 2, said apparatus comprising a furnace (1) comprising the recipient (2), the gas mixture transport line (6) and at least a portion of the carrier gas supply line (4).

5. Apparatus according to claim 3, said apparatus comprising a furnace (1) comprising the recipient (2), the gas mixture transport line (6) and at least a portion of the carrier gas supply line (4) and of the diluent gas supply line (16).

6. Apparatus according to any one of the preceding claims, wherein the pressure control device (15) is a back pressure regulating valve.

7. Installation for depositing a layer on a substrate by chemically reacting a gaseous precursor with chemical elements of the substrate, said installation comprising :

   • an apparatus according to any one of claims 1 to 6,
   • a carrier gas/precursor vapour mixture supply line (10) coupled to the outlet section (8) of the gas mixture transport line (6),
   • a deposition reactor comprising a reaction chamber (11) coupled to the carrier gas/precursor vapour mixture supply line (10).

8. Method for delivering a gaseous precursor to a reaction chamber (11), the method comprising the steps of

   • heating a precursor in a recipient (2) to a heating temperature, wherein the heating temperature is determined on the basis of a pre-determined vapour pressure of the precursor, and vaporizing the precursor at said heating temperature,
   • supplying a predefined flow of a carrier gas to the recipient (2),
   • transporting a mixture of carrier gas and precursor vapour away from the recipient through a gas mixture transport line (6), while maintaining said gas mixture transport line at said heating temperature, wherein the gas mixture transport line is provided with a pressure control device (15), configured to maintain the pressure upstream of said device at a predefined level,
   • maintaining the total pressure in the gas mixture transport line upstream of said pressure control device (15) at a predefined level,
   • reducing the total pressure of said mixture to a value lower than said predefined level, downstream of the pressure control device (15), thereby reducing the partial pressure of the precursor vapour in the mixture,
   • transporting the mixture towards the reaction chamber (11), while maintaining the mixture at a temperature lower than the heating temperature, and above the condensation temperature of the precursor vapour in the mixture.

9.  Method according to claim 8, wherein a diluent gas flow is supplied at a location in the gas mixture transport line upstream of the pressure control device (15), so that a diluted mixture flows through said device.

10. Method according to claim 8 or 9, wherein the precursor is $HfCl_4$ or $MoCl_5$ and wherein the carrier gas is chosen from the group consisting of Ar, He and $H_2$.

FIG. 1

FIG. 2

Europäisches
Patentamt

European
Patent Office

Office européen
des brevets

## EUROPEAN SEARCH REPORT

Application Number

EP 16 19 3826

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/216339 A1 (NAGASE MASAAKI [JP] ET AL) 7 August 2014 (2014-08-07) * paragraphs [0032], [0052], [0060], [0065], [0074], [0092]; figure 1 * ----- | 1-8,10 | INV. C23C16/448 C23C16/455 |
| X | EP 2 527 490 A1 (ROHM & HAAS ELECT MATERIALS [US]) 28 November 2012 (2012-11-28) * paragraph [0074]; figure 1 * * paragraphs [0052], [0097] * ----- | 1,7-9 | |
| A | US 6 699 524 B2 (KESALA JANNE [FI]) 2 March 2004 (2004-03-02) * figure 2 * ----- | 4,5 | |

| | | | TECHNICAL FIELDS SEARCHED (IPC) |
|---|---|---|---|
| | | | C23C G05D |

The present search report has been drawn up for all claims

| Place of search | Date of completion of the search | Examiner |
|---|---|---|
| The Hague | 14 March 2017 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 19 3826

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2017

| Patent document cited in search report | | Publication date | Patent family member(s) | | Publication date |
|---|---|---|---|---|---|
| US 2014216339 | A1 | 07-08-2014 | CN 103718275 A | | 09-04-2014 |
| | | | JP 5652960 B2 | | 14-01-2015 |
| | | | JP 2013033782 A | | 14-02-2013 |
| | | | KR 20140024044 A | | 27-02-2014 |
| | | | TW 201321547 A | | 01-06-2013 |
| | | | US 2014216339 A1 | | 07-08-2014 |
| | | | WO 2013018265 A1 | | 07-02-2013 |
| EP 2527490 | A1 | 28-11-2012 | CN 102794136 A | | 28-11-2012 |
| | | | EP 2527490 A1 | | 28-11-2012 |
| | | | JP 6008563 B2 | | 19-10-2016 |
| | | | JP 2012244168 A | | 10-12-2012 |
| | | | KR 20120132364 A | | 05-12-2012 |
| | | | TW 201305381 A | | 01-02-2013 |
| | | | US 2012298040 A1 | | 29-11-2012 |
| | | | US 2015167172 A1 | | 18-06-2015 |
| US 6699524 | B2 | 02-03-2004 | FI 20001166 A | | 16-11-2001 |
| | | | JP 5241982 B2 | | 17-07-2013 |
| | | | JP 2001323374 A | | 22-11-2001 |
| | | | TW 524875 B | | 21-03-2003 |
| | | | US 2001042523 A1 | | 22-11-2001 |
| | | | US 2004086642 A1 | | 06-05-2004 |

EPO FORM P0459

For more details about this annex : see Official Journal of the European Patent Office, No. 12/82